# EUROPEAN PATENT APPLICATION

(11) **EP 2 586 557 A1**
(43) Date of publication of application: **01.05.2013**
(21) Application number: 11186731.3
(22) Date of filing: 26.10.2011
(51) Int. Cl.: B23D 61/18, B23D 65/00

(54) **Saw and sawing element with diamond coating and method for producing the same**

(71) Applicant: Applied Materials Switzerland Sàrl, 1033 Cheseaux-sur-Lausanne (CH)
(72) Inventor: Iyer, Subramani, San Jose, CA California 95117 (US)
(74) Representative: Zimmermann & Partner

(57) **Abstract**

A sawing element (10) for a saw is provided. The element (10) includes a core (30), and a continuous outer layer of diamond (20). A respective saw (60) and a method for producing the element (10) are also provided.

## Description

### FIELD OF THE INVENTION

Embodiments of the present invention relate to a diamond-coated element for a saw for sawing a workpiece, and a method of producing the element. More particularly, they relate to diamond-coated wire for a saw.

### BACKGROUND OF THE INVENTION

Wire saws are used to cut workpieces, for example silicon workpieces are cut using wire saws for cropping, squaring, and wafering. Wire saws are also used for cutting other materials.

Different types of wire may be used in wire saws, for example those used in combination with silicon carbide particles in a slurry, and diamond wire often used in combination with a coolant. Generally, a hard material such as silicon carbide or diamond abrades the workpiece to make the cut. Typically, diamond-coated wire comprises a steel core, which is coated, respectively embedded, on its surface with diamond particles. The diamond particles do not form a uniform layer, but slightly project outwards from the steel surface, which is one of the major factors contributing to the abrasive force when such a wire is used for sawing.

During cutting, the wire is moved rapidly along its length (horizontally), and the workpiece is moved comparatively slowly by a workpiece supply plate in a cutting direction substantially perpendicular (vertically) to the direction of fast wire motion. A vertical force of the wire on the workpiece is thus applied along the cutting direction, and the reactive force of the workpiece on the wire causes the wire to be deformed or bowed in the direction opposite to the cutting direction.

It is a general aim to increase cutting speed, for example by moving the wire faster in a wire saw, or by enhancing the force with which the wire is pressed onto the good to be sawn. These measures similarly require an enhancement of the stability of the wires to maintain resistency against breakage. However, it is also an object, particularly in sawing relatively expensive silicon for semiconductors, to minimize a diameter of the wire in order to reduce kerf loss. The two objects are detrimental.

In view of the above, it is desirable to have a sawing element which avoids the cited disadvantages of conventional steel saw wire with embedded diamonds on its surface.

### SUMMARY

According to an embodiment, a sawing element for a saw is provided. The element includes a core and a continuous outer layer of diamond.

According to a further embodiment, a saw is provided. The saw includes a frame, a sawing element mounted to the frame, the element including a core and a continuous outer layer of diamond.

According to a yet further embodiment, a method of producing a sawing element is provided. The method includes providing a core, and providing a continuous outer layer of diamond on the core.

According to a yet further embodiment, the use of a sawing element in a sawing process is provided. The used sawing element includes a core, and a continuous outer layer of diamond.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:

Fig. 1 shows a schematic cross section of a sawing element according to embodiments;

Fig. 2 shows a schematic cross section of a further sawing element according to embodiments;

Fig. 3 shows a schematic perspective front view of a yet further sawing element according to embodiments;

Fig. 4 schematically shows a wire saw according to embodiments;

Fig. 5 schematically shows a cross sectional side view of a sawing element according to embodiments;

Fig. 6 shows a deposition chamber for producing sawing elements according to embodiments.

### DETAILED DESCRIPTION OF THE INVENTION

Herein, wire saw, wire saw device, wire sawing device, and wire cutting device are used interchangeably. Herein, workpiece support plate and workpiece supply plate are used interchangeably. Herein, the terms sawing and cutting are used interchangeably; and wafer-cutting wire saw and waferer are used interchangeably. Herein, a workpiece may include one or more separate pieces, for example a plurality of semiconductor pieces or ingots. Herein, the wire saw can cut using a single wire, multiple wires, one or more rows of one or more wires, or one or more webs of one or more wires; wire may refer to multiple wires. Herein a sensor may also perform functions in addition to sensing, for example an ultrasonic sensor may be an ultrasonic transducer and vice versa, so that an ultrasonic sensor may both generate and detect ultrasonic pulses and waves. Herein, the phrases, "in relation to," "in reference to," and "relative to" are used interchangeably. Herein, the term "continuous coating" on a subject refers to a layer which covers the coated subject entirely and coherently, i.e. without gaps (except at intended locations). This may for example be tested by a check if a chemical substance reacts with the core despite the presence of the coating, or by optical inspection. "Continuous" as used herein does not necessarily include that the coating has a homogeneous thickness. A layer or coating may thus be continuous, but have a varying thickness and/or a surface roughness. Herein, a layer "of diamond" may include other elements up to a mass percentage of 30 percent, and is still regarded to be "of diamond".

Reference will now be made in detail to the various embodiments of the invention, one or more examples of which are illustrated in the figures. Each example is provided by way of explanation and is not meant as a limitation. Further, features illustrated or described as part of one embodiment can be used on or in conjunction with other embodiments to yield yet a further embodiment. It is intended that the description includes such modifications and variations.

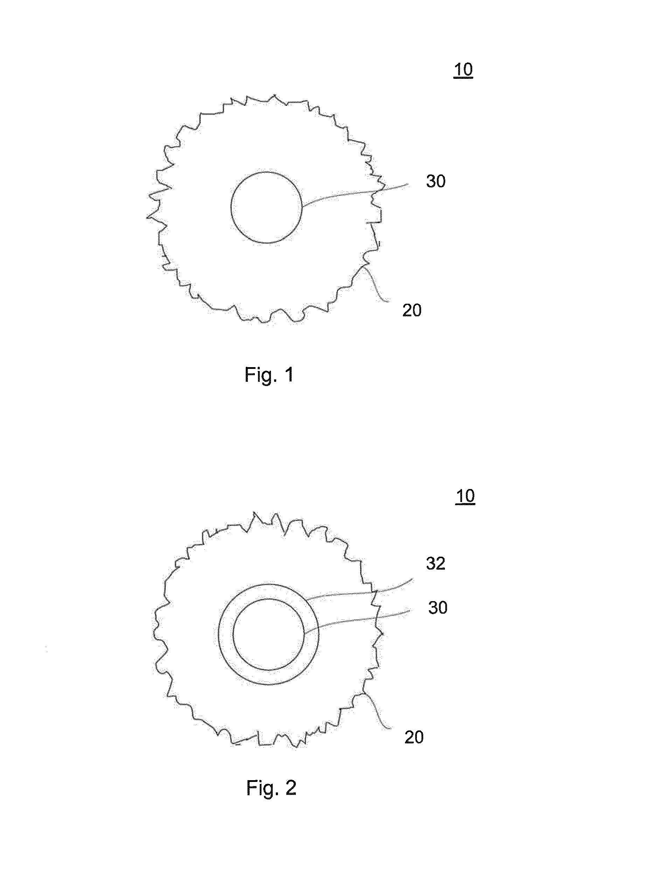

Fig. 1 shows a cross section of a sawing element 10 according to embodiments. A core 30 is coated with a continuous outer layer 20 of diamond. Typically, the core includes metal, more typically steel, nickel, or titanium, even more typically a steel including Ni and/or Cr. In other embodiments, the core 30 may also include a fibrous material, such as carbon fiber. In the following, it is exemplarily assumed that the core is metallic. Further, it is assumed that the core 30 has the shape of a wire, and hence has a circular cross section and a tubular shape with a length much greater than the diameter. The outer layer 20 of diamond typically has a surface roughness (cf. Fig. 1) which exceeds the roughness which would be achieved by a typical CVD deposition process as known from the art. This elevated roughness is intentionally achieved during deposition of outer layer 20, typically by modifying parameters of the deposition process during the process. This is laid out further below in greater detail.

In embodiments where the core 30 is a wire, the core may have a typical diameter of 25 µm to 100 µm, more typically 30 µm to 80 µm. The diamond coating may have a thickness from 10 µm to 50 µm, more typically from 15 µm to 25 µm. The diameter of the coated wire is thus from about 40 µm to 200 µm, more typically from 45 µm to 100 µm, which is below typical diameters for conventional diamond embedded wire. The diamond coatings herein are typically provided by physical vapor deposition, typically using an aliphatic hydrocarbon, more typically methane, as a component of a process gas.

The strength of a sawing element according to embodiments far surpasses existing comparable wires with diamonds embedded on the surface. Further, there is no risk of diamonds on the surface becoming dislodged during sawing, as in conventional wire. Thus, the lifetime of the sawing elements is expected to be significantly higher than that of wires with embedded diamonds. The diamond-coated elements described herein have exterior diamond facets, which provide for the abrasive effect, as part of the superstructure of the sawing element. It is expected that their overall lifetime is much higher than that of conventional diamond-embedded wire, which saves cost as well as maintenance and down times. Additionally, due to the smaller diameters, kerf loss is greatly reduced.

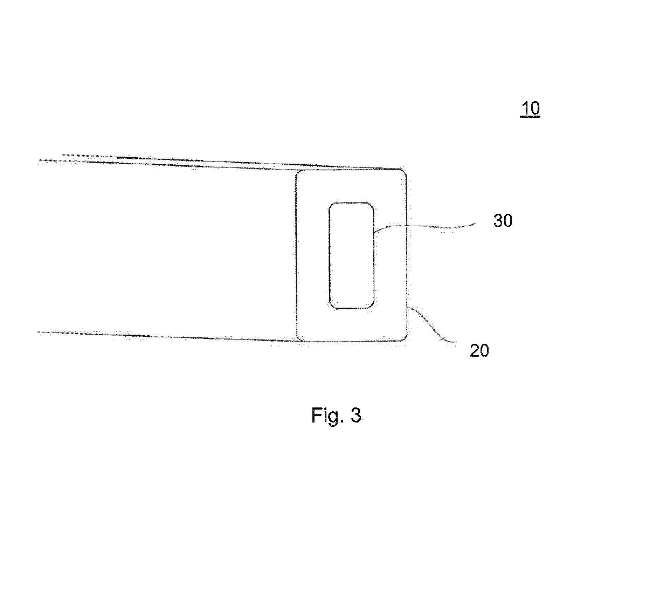

Between core 30 and diamond layer 20, an intermediate layer of a carbide 35 may be provided in embodiments, which is shown in Fig. 2. The intermediate layer 35 can improve adhesion between core 30 and coating 20 and may have a thickness from 100 nm to 5 µm, more typically from 120 nm to 3 µm. Further, in embodiments, various other shapes for the core 30 are possible, for example a strip having a rectangular cross section, which is schematically shown in Fig. 3, wherein the surface roughness of layer 20 is not shown for illustrational purposes. The sawing element 10 may in embodiments also have a disc shape (not shown).

Typically, the diamond layer is applied to the typically metallic core 30 using a physical or chemical deposition technique, such as chemical vapor deposition. By using this technique, it can be assured that the resulting layer 20 of diamond resembles the properties of a rigid diamond in terms of hardness and strength.

As the outer layer 20 has the properties of diamond, it is (regarding the typical dimensions given above) rigid against bending of the coated sawing element 10. Hence, sawing elements according to embodiments will, depending on the thickness of the coating, have a higher rigidity and lower mechanical stability against breaking through bending than conventional steel wire with embedded diamonds. Conventional steel wire or conventional diamond-coated wire, having no homogeneous outer layer, is typically provided on spools bearing kilometers of wire. With the present diamond-coated wire 10, it is not easily possible to supply this wire on spools due to the more rigid character.

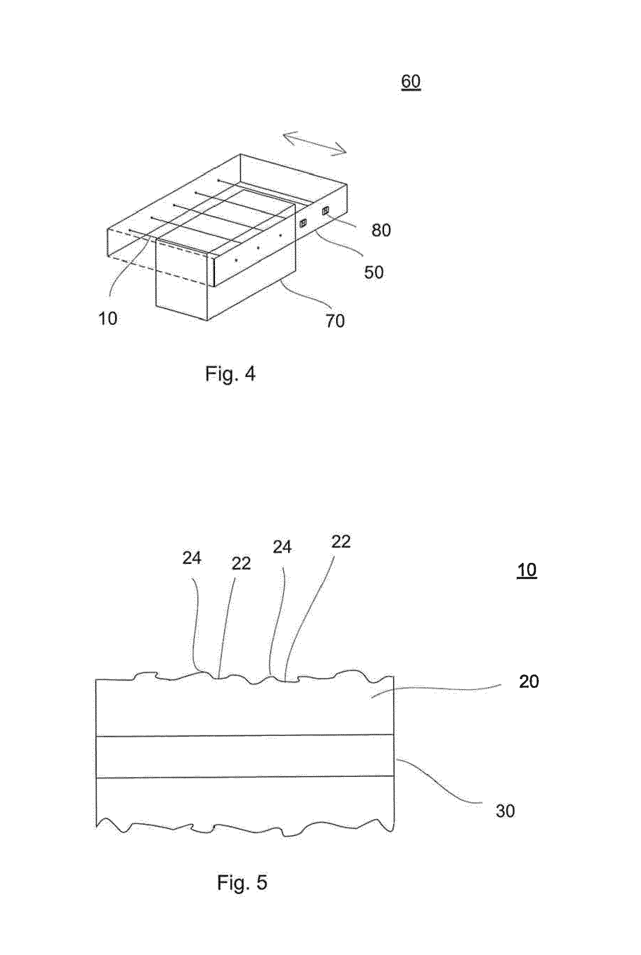

Rather, the sawing element 10 can, according to embodiments, for example be used in conjunction with a rigid frame 50 to which a plurality of elements are attached, which is shown in Fig. 4. These sawing elements 10, henceforth also called diamond strings, are clamped in an array as shown. Hence, an arrayed saw 60 of rigid diamond strings is provided, which then can be used to, for example, saw a silicon ingot 70. By moving the saw 60 back and forth in direction of the arrows, the sawing elements/diamond strings 10 are moved relative to the brick 70 and saw it. It is understood that this is only a non-limiting example of a wire saw and a sawing process according to embodiments, and that a variety of other configurations are possible using the sawing elements according to embodiments.

In embodiments, the use of a diamond-coated sawing element 10, such as in a saw 60, may be accompanied by the application of ultrasound to the sawing elements 10 and/or to the frame 50, for example from ultrasound emitters 80 as shown in Fig. 4. The ultrasound helps in improving the relative velocity of the diamond strings 10 with respect to the silicon substrate 70.

In embodiments, sawing with diamond-coated elements 10 as described herein may be supported by using surfactants, lubricants or accelerants. As the sawing elements 10 according to embodiments have a continuous outer layer 20 of diamond, they are chemically much more stable against a number of substances than conventional steel wire with embedded diamonds. This is due to the fact that an additive used in the sawing process has no direct contact to the metallic core 30, but only to the diamond layer 20. Hence, substances corrosive to steel or other metals employed for the core may be employed in the sawing process, such as, for example, KOH and HF. They can help to further accelerate the sawing or slicing process. Thus, the use of diamond strings 10 in a saw 60 permits the use of caustic etchants which could not be used with the existing sawing techniques, respectively with a wire having an exposed steel surface.

In embodiments, a diamond string saw 60 as shown in Fig. 4 can be equipped with a monitoring system. This may, e.g., include a sensor for resistivity, that could be attached to the ends to determine wear/tear of the strings 10. Accordingly, based on the date process parameters such as cutting feed, feed rate etc. may be adapted by a controller to compensate for the use of the strings 10.

Fig. 5 shows a schematic cross sectional side view on a sawing element 10 according to embodiments. The wire 10 has alternating zones of smaller diameter 22 and zones of bigger diameter 24, as well in longitudinal direction of the wire as in a circumferential direction (not shown, refer to Figs. 1 and 2). The drawings herein are generally for illustrative purposes only and do not necessarily reflect the actual dimensions, surface roughnesses or surface shapes according to embodiments.

The profile of wire 10 having zones of smaller and bigger diameter serves for providing the abrasive effect if the wire is moved lengthwise over a body to be sawed. This abrasive property is achieved by controlling the deposition conditions. In embodiments, an initial deposition of mono-crystalline diamond for adhesion to the wire core 30 is carried out first. This relatively smooth coating is typically followed by a further, polycrystalline layer to generate facets for the abrasion property, i.e., the facets provide for zones of smaller 22 and bigger 24 diameter of the coating 20. The roughness of the deposited diamond layer 20 can, for example, be influenced by the application rate during deposition. With a growing deposition rate per time, the roughness becomes higher. This is used in embodiments to produce the intended surface roughness of the surface of the outer diamond coating. A typical average surface roughness of the diamond coating, in the case of wire for silicon sawing, is from 3 µm to 30 µm, more typically from 5 µm to 20 µm. In embodiments, also greater surface roughnesses of up to 100 µm or even 200 µm can be desirable, for example when the sawing wire has a diameter of 0.5 mm to 2 mm. Hence, the surface roughness strongly depends on the dimensions of the sawing element and the intended material to be sawed.

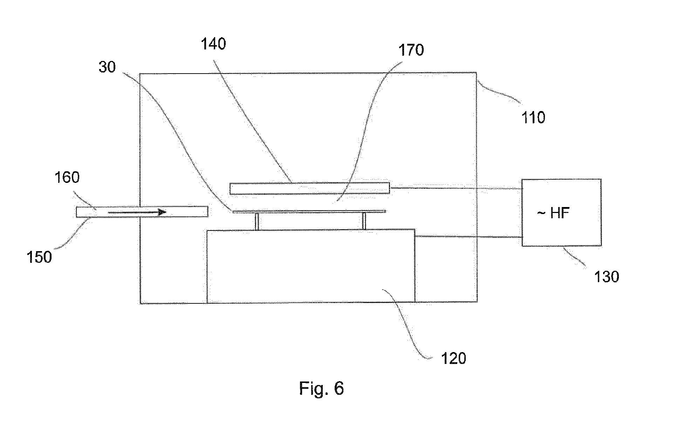

An exemplary method for producing a sawing element according to embodiments is as follows. A piece of wire, which forms core 30, is placed into a vacuum chamber 110 for chemical vapor deposition, as shown in Fig. 6. The core 30 is placed on a table 120. The table 120 is connected to a HF power supply 130, as well as an electrode 140 mounted over the table 120, such that core 20 is placed between table 120 and electrode 140. Via an inlet 150, a process gas (precursor gas) 160 is injected into chamber 110. Via a high frequency voltage from HF power source 130, a plasma 170 is produced and maintained between the table 120 and the electrode 140. By adjusting the HF power supply 130 and the flow rate of process gas 160, properties of the plasma 170 can be influenced. The process gas (precursor gas) 160 may typically be a mixture between hydrogen and typically methane, or another aliphatic hydrocarbon.

The core 30 is exemplarily chosen to be a steel wire, but may also be formed of nickel, of titanium, or of alloys of the former. The wire may principally include any metal or alloys or other suitably stable materials which can form stable carbides on their surface. The steel wire may have a length from 10 cm to several meters, typically from 50 cm to 1.5 m. The wire is then typically coated with a monocrystalline diamond coating. Subsequently, a polycrystalline coating of diamond is deposited on the first diamond coating to yield the facets which will provide for the abrasive effect during sawing, hence for achieving the desired surface roughness. The monocrystalline and the polycrystalline coatings (layers) together form outer diamond layer 20.

In embodiments, the diamond formation on core 30 or optional intermediate layer 35 begins with nucleation. This can be done by simply dusting the wire with diamond and then subjecting it to chemical vapor deposition (CVD), or through the formation of carbide and subsequent chemical nucleation.

The formation of polycrystalline diamonds may be promoted, as laid out above, by enhancing a deposition rate of diamond, e.g. by enhancing a flow rate of the precursor gas including a hydrocarbon into the process chamber. Additionally or alternatively, in embodiments, an additive gas, typically oxygen and/or nitrogen, may be added to the precursor gas. These impurities will also promote the formation of polycrystalline diamond, which may be accompanied by a reduced process temperature and an enhanced deposition rate.

In embodiments, methods of achieving gas phase activation of the process gas can also include the use of a hot filament and microwave cracking.

While the foregoing is directed to embodiments of the present invention, other and further embodiments of the invention may be devised without departing from the basic scope thereof, and the scope thereof is determined by the claims that follow.

## Claims

1. A sawing element for a saw, comprising:
- a core, and
- a continuous outer layer of diamond.

2. The sawing element of claim 1, wherein the core comprises metal.

3. The sawing element of claims 1 or 2, wherein the core comprises Ni.

4. The sawing element of any preceding claim, wherein the core comprises steel.

5. The sawing element of any preceding claim, further comprising:
- a carbide layer between the core and the outer layer of diamond.

6. The sawing element of any preceding claim, wherein the core is a wire.

7. The sawing element of claim 6, wherein a diameter of the wire is 100 µm or less.

8. The sawing element of any preceding claim, wherein the continuous outer layer has an average thickness of 50 µm or less, and wherein the continuous outer layer is preferably provided via chemical vapour deposition.

9. The sawing element of any preceding claim, wherein the continuous outer layer has an average surface roughness of 5 µm to 30 µm.

10. A saw, comprising:
- a frame,
- a sawing element mounted to the frame, the element comprising:
- a core, and
- a continuous outer layer of diamond.

11. The saw of claim 10, wherein the core is a wire or a strip.

12. A method of producing a sawing element, comprising:
- providing a core, and
- depositing a continuous outer layer of diamond on the core.

13. The method of claim 12, further comprising:
- depositing a carbide layer between the core and the outer layer.

14. The method of claims 12 or 13, wherein the continuous outer layer of diamond is provided to have an average surface roughness of 5 µm to 30 µm, and wherein the outer layer of diamond is provided via chemical vapour deposition, and wherein the surface roughness is obtained by a modification of at least one process parameter during the deposition of diamond, wherein the at least one parameter comprises at least one element from the list consisting of: a carbon deposition rate, a precursor gas flow rate, a process temperature, a precursor additive gas concentration, a precursor oxygen concentration, and a precursor nitrogen concentration.

15. The use of a sawing element in a sawing process, wherein the sawing element comprises:
- a core, and
- a continuous outer layer of diamond.
